# EUROPEAN PATENT APPLICATION

(11) **EP 4 270 777 A1**
(43) Date of publication of application: **01.11.2023**
(21) Application number: 21910941.0
(22) Date of filing: 23.12.2021
(51) Int. Cl.: H02P 29/024

(54) **ABNORMALITY DETERMINING DEVICE, MOTOR CONTROL DEVICE, ABNORMALITY DETERMINING METHOD, AND PROGRAM**

(30) Priority: 23.12.2020 JP 2020213145
(71) Applicant: Panasonic Intellectual Property Management Co., Ltd., Osaka-shi, Osaka 540-6207 (JP)
(72) Inventor: TANAKA, Tatsuhiro, Osaka 540-6207 (JP); FUJIWARA, Hiroshi, Osaka 540-6207 (JP)
(74) Representative: SSM Sandmair
(86) International application number: PCT/JP2021/047801
(87) International publication number: WO 2022/138801

(57) **Abstract**

An anomaly determining device (25) includes a sensor information acquirer (23) and a determiner (24). The sensor information acquirer acquires sensor information output in time sequence from each of two sensors (50, 60) that detect different physical quantities of a moving part (40) that is subjected to positioning control. The determiner determines, when the moving part(40) is located within a predetermined range from a target position for positioning, the presence or absence of an anomaly in at least one of the two sensors (50, 60) in accordance with the acquired sensor information and outputting a result of the determination.

## Description

### [Technical Field]

The present disclosure relates to an anomaly determining device or the like for determining anomalies in sensors that detect physical quantities of a moving part that is subjected to positioning control.

### [Background Art]

Patent Literature (PTL) 1 discloses a system that includes a motor control device including both a controller and an imaging device. This system transmits information output from the imaging device to the controller and transmits command information that is calculated by the controller in accordance with the information output from the imaging device and then given to a motor.

### [Citation List]

### [Patent Literature]

[PTL 1]
Japanese Unexamined Patent Application Publication No. 2005-267138

### [Summary of Invention]

### [Technical Problem]

The above system disclosed in PTL 1 is, however, susceptible to improvement.

It is an object of the present disclosure to provide an anomaly determining device or the like that is capable of further improvement.

### [Solution to Problem]

An anomaly determining device according to one aspect of the present disclosure includes a sensor information acquirer that acquires sensor information output in time sequence from each of two sensors that detect different physical quantities of a moving part that is subjected to positioning control, and a determiner that, when the moving part is located within a predetermined range from a target position for positioning, determines presence or absence of an anomaly in at least one of the two sensors in accordance with the sensor information acquired and outputs a result of the determination.

A motor control device according to one aspect of the present disclosure is a motor control device for controlling a position of a moving part by driving a motor and includes the anomaly determining device described above.

An anomaly determining method according to one aspect of the present disclosure is an anomaly determining method to be executed by a computer. The anomaly determining method includes acquiring sensor information output in time sequence from each of two sensors that detect different physical quantities of a moving part that is subjected to positioning control, and when the moving part is located within a predetermined range from a target position for positioning, determining presence or absence of an anomaly in at least one of the two sensors in accordance with the sensor information acquired, and outputting a result of the determining.

A program according to one aspect of the present disclosure is a program for causing a computer to execute steps included in the anomaly determining method described above.

### [Advantageous Effects of Invention]

The anomaly determining device or the like according to one aspect of the present disclosure is capable of further improvement.

### [Brief Description of Drawings]

[FIG. 1]

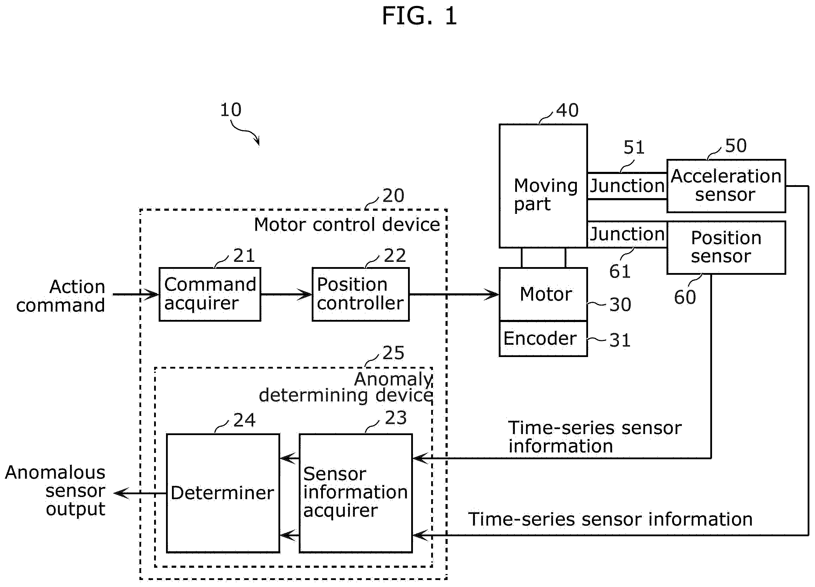

   FIG. 1 is a block diagram illustrating a configuration of a motor control system according to an embodiment.
[FIG. 2]

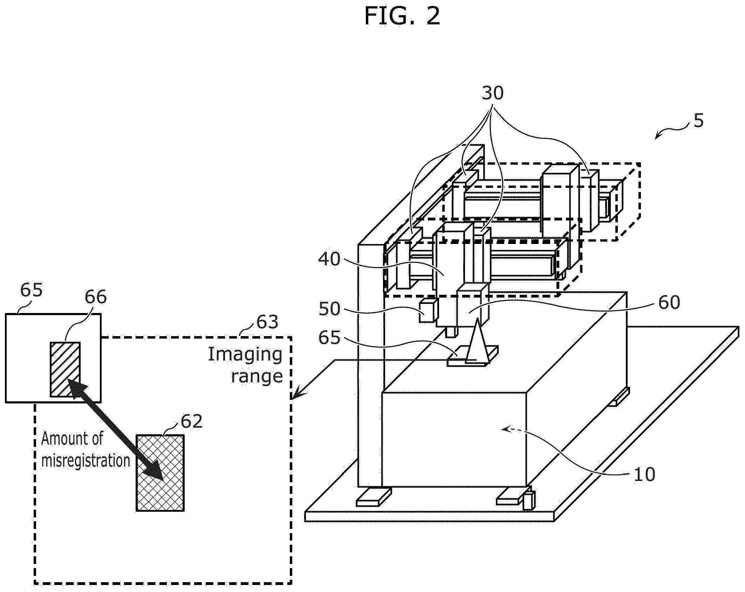

   FIG. 2 is a perspective view of a production device to which the motor control system according to the embodiment has been applied.
[FIG. 3]

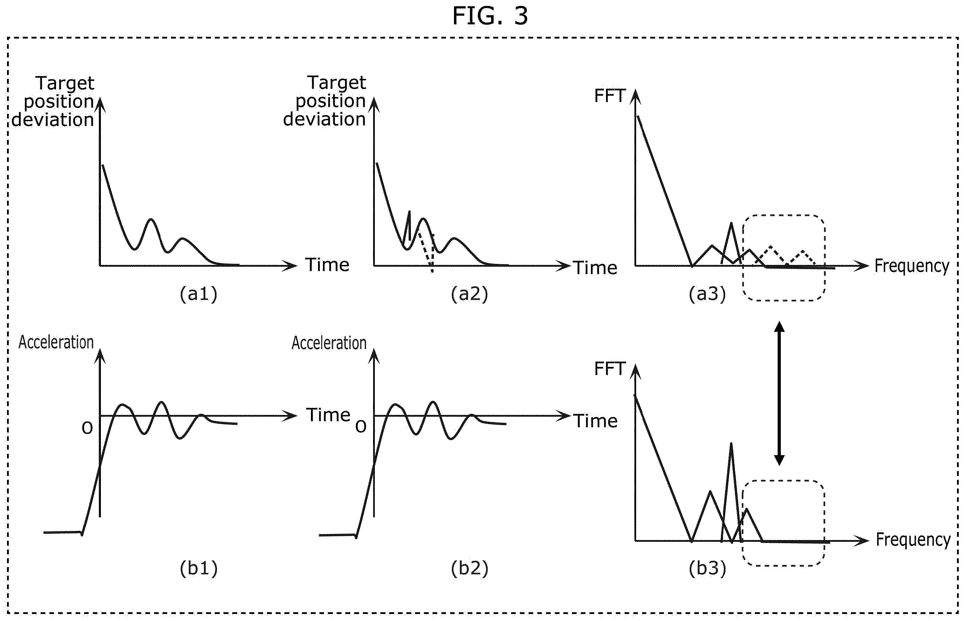

   FIG. 3 is a diagram showing one example of sensor information output from a position sensor and sensor information output from an acceleration sensor according to the embodiment.
[FIG. 4]

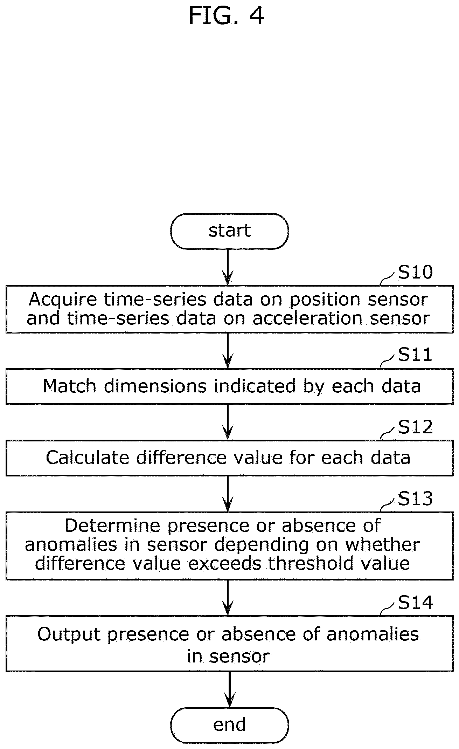

   FIG. 4 is a flowchart showing a first example of operations performed by the anomaly determining device according to the embodiment.
[FIG. 5]

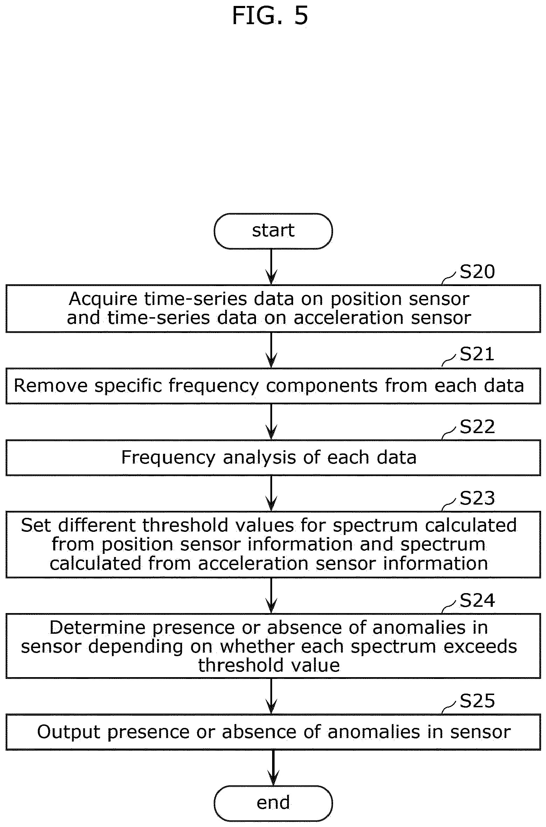

   FIG. 5 is a flowchart showing a second example of the operations performed by the anomaly determining device according to the embodiment.
[FIG. 6]

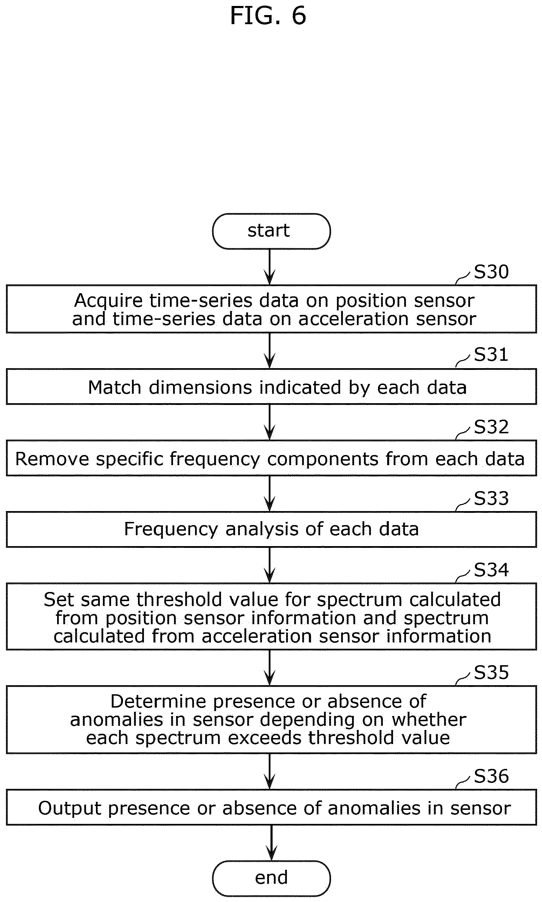

   FIG. 6 is a flowchart showing a third example of the operations performed by the anomaly determining device according to the embodiment.
[FIG. 7]

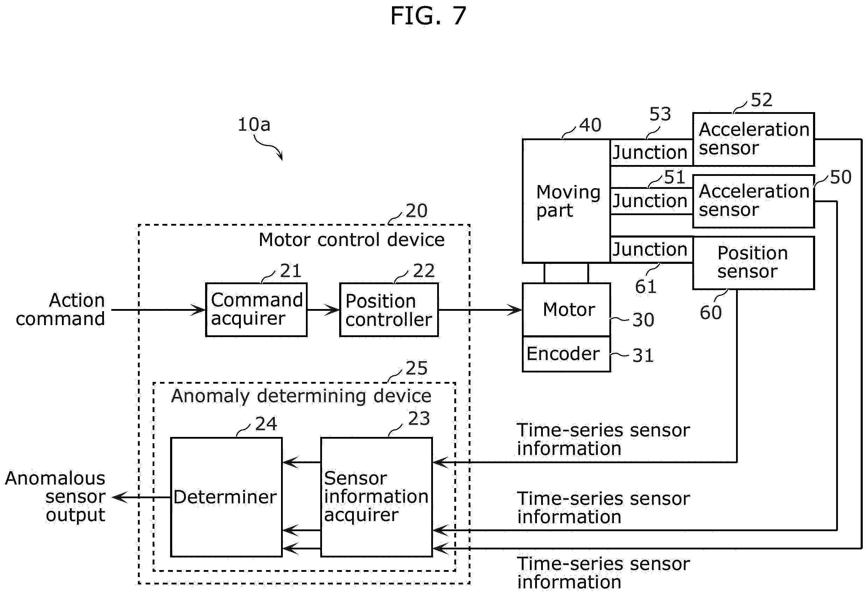

   FIG. 7 is a block diagram illustrating a configuration of a motor control system according to a variation of the embodiment.
[FIG. 8]

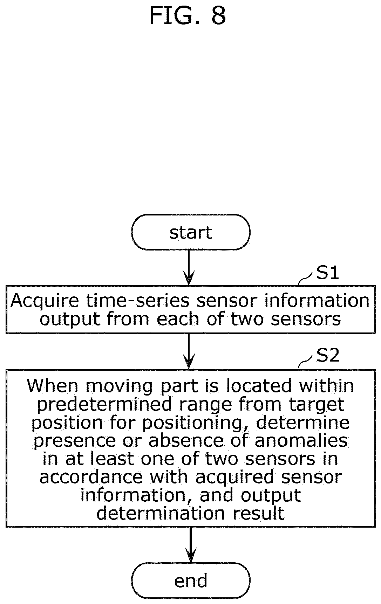

   FIG. 8 is a flowchart showing one example of an anomaly determining method according to another embodiment.

### [Description of Embodiments]

### (Circumstances Leading to One Embodiment of the Present Disclosure)

To control the positon of a moving part, sensors such as an acceleration sensor and a camera may be installed on equipment in addition to a servomotor. At this time, if any of these sensors is loosely fastened on the equipment due to conditions such as deterioration of the equipment over time, sensor information on the sensor may take on an anomalous value and inhibit appropriate positioning control. Determining the presence of anomalies in sensors caused by such loosened fastening is not easy for anyone and, in particular, difficult for beginners. In view of this, the inventors of the present disclosure have conceived an anomaly determining device or the like described below that is capable of determining the presence of anomalies in sensors with ease.

An anomaly determining device according to one aspect of the present disclosure includes a sensor information acquirer that acquires sensor information output in time sequence from each of two sensors that detect different physical quantities of a moving part that is subjected to positioning control, and a determiner that, when the moving part is located within a predetermined range from a target position for positioning, determines presence or absence of an anomaly in at least one of the two sensors in accordance with the sensor information acquired and outputs a result of the determination.

Since the anomaly determining device automatically determines the presence or absence of anomalies in at least one of the two sensors that detect different physical quantities, it is possible to determine the presence of anomalies in the sensors with ease.

The two sensors may include an acceleration sensor and a position sensor, the acceleration sensor detecting and outputting an acceleration of the moving part, the position sensor detecting and outputting a location deviation of the moving part from the target position.

In this way, the two sensors may be an acceleration sensor and a position sensor.

The acceleration sensor may be fixed to the moving part, and the position sensor may be fixed to the moving part or an object that is different from the moving part and placed at the target position.

The fastening of the sensors to the moving part is likely to be loosened due to oscillations or the like during motion. The present disclosure enables easily determining the presence or absence of anomalies in the sensors and thereby makes it possible to easily determine looseness in fastening of the sensors to the moving part.

The determiner may determine the presence or absence of an anomaly by comparing a fluctuation indicated by the sensor information output from at least one of the two sensors with a first threshold value.

If there is looseness in fastening of at least one of the two sensors, fluctuations indicated by the sensor information on the sensor having loosened fastening may become anomalous (e.g., fluctuations may show a sharp transition). Accordingly, it is possible to determine that the sensor whose sensor information indicates sharp fluctuations is anomalous.

The determiner may determine the presence or absence of an anomaly by making a comparison between physical quantities indicated by the sensor information output from each of the two sensors.

If there is looseness in fastening of any of the two sensors, a difference in physical quantity indicated by the sensor information on each sensor may increase. Accordingly, if there is a large difference in physical quantity indicated by the sensor information on each of the two sensors, it is possible to determine that either of the two sensors is anomalous.

The determiner may perform the comparison after performing processing for matching a dimension of a physical quantity indicated by the sensor information output from each of the two sensors to a dimension of one of a change over time, a time derivative of the change, and a second-order time derivative of the change.

In this way, an accurate comparison between the physical quantiles indicated by the sensor information on each sensor is achieved by matching the dimensions of the sensor information on each sensor to each other.

The determiner may determine the presence or absence of an anomaly by comparing a physical quantity indicated by the sensor information output from each of the two sensors with a second threshold value.

If there is looseness in fastening of at least one of the two sensors, the physical quantity indicated by the sensor information on the sensor having loosened fastening may become anomalous (e.g., the physical quantity may take on a large value). Accordingly, it is possible to determine that the sensor whose sensor information indicates an anomalous physical quantity is anomalous.

The determiner may determine the presence or absence of an anomaly by performing frequency analysis on the sensor information output from each of the two sensors and comparing a spectrum obtained with the second threshold value.

In this way, after the frequency analysis, the physical quantities indicated by the sensor information are compared with the second threshold value. This allows accurate determination of the presence or absence of anomalies.

A motor control device according to one aspect of the present disclosure is a motor control device for controlling a position of a moving part by driving a motor and includes the anomaly determining device described above.

Accordingly, it is possible to provide a motor control device capable of determining the presence of anomalies in sensors with ease.

An anomaly determining method according to one aspect of the present disclosure is an anomaly determining method to be executed by a computer. The anomaly determining method includes acquiring sensor information output in time sequence from each of two sensors that detect different physical quantities of a moving part that is subjected to positioning control, and when the moving part is located within a predetermined range from a target position for positioning, determining presence or absence of an anomaly in at least one of the two sensors in accordance with the sensor information acquired, and outputting a result of the determining.

Accordingly, it is possible to provide an anomaly determining method capable of determining the presence of anomalies in sensors with ease.

A program according to one aspect of the present disclosure is a program for causing a computer to execute steps included in the anomaly determining method described above.

Accordingly, it is possible to provide a program that enables determining the presence of anomalies in sensors with ease.

The following describes a specific example of an anomaly determining device according to one aspect of the present disclosure with reference to drawings. The embodiment described below shows a general or specific example of the present disclosure. Therefore, numerical values, shapes, materials, constituent elements, arrangement and connection form of constituent elements, steps (processes), the order of steps, and so on illustrated in the following embodiment are mere examples, and do not intend to limit the scope of the present disclosure. The figures are schematic diagrams and are not necessarily precise illustrations. Moreover, constituent elements that are substantially the same are given the same reference signs throughout the drawings, and their detailed description may be omitted or simplified.

### [Embod iment]

The following describes a motor control system according to an embodiment. This motor control system is a system for controlling a motor to move a moving part connected to the motor to a target position. The motor control system may, for example, be a production device for mounting components on a substrate.

FIG. 1 is a block diagram illustrating a configuration of motor control system 10 according to an embodiment.

As illustrated in FIG. 1, motor control system 10 includes motor control device 20, anomaly determining device 25, motor 30, encoder 31, moving part 40, acceleration sensor 50, position sensor 60, and junctions 51 and 61. The description here is given of an example in which motor control device 20 includes anomaly determining device 25.

Motor 30 is driven by a driving signal output from motor control device 20. Motor 30 here is described as a rotary motor. It is, however, noted that motor 30 is not necessarily limited to a rotary motor and may, for example, be a linear motor. The driving signal may, for example, be a current for rotating motor 30.

Encoder 31 detects the position of motor 30 and outputs an encoder signal indicating the detected position of motor 30 to motor control device 20.

Moving part 40 is connected to motor 30. For example, in the case where motor control system 10 is a production device (e.g., a component mounter) for mounting components on a substrate, moving part 40 may serve as a header that transports the components to their mounting positions.

Acceleration sensor 50 is fixed to moving part 40 and configured to detect the acceleration of moving part 40 and to output sensor information indicating the detected time-series acceleration of moving part 40 to motor control device 20 (specifically, anomaly determining device 25). The acceleration is one example of the physical quantities of moving part 40 detected by sensors. Instead of or in addition to acceleration sensor 50, a speed sensor or a gyroscopic sensor may be fixed to moving part 40.

Position sensor 60 is fixed to moving part 40 and configured to detect a location deviation of moving part 40 relative to target position 66 for positioning (the location deviation is also referred to as the "target position deviation"), the details of which will be described later, and to output sensor information indicating the detected time-series target position deviation of moving part 40 to motor control device 20 (specifically, anomaly determining device 25). The target position deviation is one example of the physical quantities of moving part 40 detected by sensors. Position sensor 60 may, for example, be an imaging device (camera). Alternatively, position sensor 60 may be fixed to an object different from moving part 40 and placed at target position 66 (e.g., an object placed around target position 66). There are no limitations on the target to which position sensor 60 is fixed, as long as moving part 40 is fixed at a position at which it is possible to detect that moving part 40 is located within a predetermined range from target position 66.

Junction 51 is a fastening member for fixing acceleration sensor 50 to moving part 40. For example, the fastening of acceleration sensor 50 to moving part 40 may be loosened due to aged deterioration. In particular, oscillations or the like associated with the movement of moving part 40 are likely to cause looseness in fastening of acceleration sensor 50 to moving part 40.

Junction 61 is a fastening member for fixing position sensor 60 to moving part 40. For example, the fastening of position sensor 60 to moving part 40 may be loosened due to aged deterioration. In particular, oscillations or the like associated with the movement of moving part 40 are likely to cause looseness in fastening of position sensor 60 to moving part 40. In the case where position sensor 60 is fixed to an object placed at target position 66, junction 61 may serve as a fastening member for fixing position sensor 60 to the object. For example, the fastening of position sensor 60 to the object may be loosened due to aged deterioration.

For example, a state in which fastening is not loosened may be hereinafter referred to as being normal, and a state in which fastening is loosened as being anomalous.

Motor control device 20 is a device that drives motor 30 to control the position of moving part 40. Motor control device 20 includes command acquirer 21 and position controller 22 as constituent elements for controlling the position of moving part 40. As described above, although an example in which motor control device 20 includes anomaly determining device 25 is described here, anomaly determining device 25 may be provided separately from motor control device 20.

Anomaly determining device 25 is a device for determining the presence or absence of anomalies in two sensors (here, acceleration sensor 50 and position sensor 60). Anomaly determining device 25 includes sensor information acquirer 23 and determiner 24 as constituent elements for determining the presence or absence of anomalies in the two sensors.

Motor control device 20 and anomaly determining device 25 are realized by a computer that includes, for example, a processor and memories. Examples of the memories include a read only memory (ROM) and a random access memory (RAM) that are capable of storing programs to be executed by the processor. Command acquirer 21 and position controller 22 as well as sensor information acquirer 23 and determiner 24 are realized by the processor that executes the programs stored in the memories.

Command acquirer 21 acquires an action command. The action command includes a command signal for setting the position of moving part 40 to a target position. For example, the command signal may be one of a position command signal indicating a position command for setting the position of moving part 40 to the target position, a speed command signal indicating a speed command for setting the position of moving part 40 to the target position, an acceleration command signal indicating an acceleration command for setting the position of moving part 40 to the target position, and a torque command signal indicating a torque command for setting the position of moving part 40 to the target position.

Position controller 22 generates a driving signal for driving motor 30 to move moving part 40 to the target position, , in accordance with the action command acquired by command acquirer 21, the encoder signal acquired by encoder 31, the sensor information acquired by acceleration sensor 50, and the sensor information acquired by position sensor 60, and outputs the generated driving signal to motor 30. For example, in response to the action command acquired by command acquirer 21, position controller 22 generates a driving signal by performing feedback control for feeding back the sensor information acquired by sensor information acquirer 23.

Sensor information acquirer 23 acquires sensor information that is output in time sequence from each of the two sensors (here, acceleration sensor 50 and position sensor 60) that detect different physical quantities of moving part 40 that is subjected to positioning control. Specifically, sensor information acquirer 23 acquires sensor information indicating a time-series acceleration of moving part 40 from acceleration sensor 50, and also acquires sensor information indicating a time-series target position deviation of moving part 40 from position sensor 60.

When moving part 40 is located within a predetermined range from target position 66 for positioning, determiner 24 determines, in accordance with the acquired sensor information, the presence or absence of anomalies in at least one of the two sensors and outputs the result of the determination. For example, the output determination result may indicate that acceleration sensor 50 is anomalous, or that position sensor 60 is anomalous, or that both acceleration sensor 50 and position sensor 60 are anomalous, or that at least one of acceleration sensor 50 and position sensor 60 is anomalous although which of the sensors is anomalous is unknown.

For example, determiner 24 determines the presence or absence of anomalies by comparing fluctuations indicated by the sensor information output from at least one of the two sensors with a first threshold value. The first threshold value may, for example, be preset depending on fluctuations indicated by the sensor information output from normal acceleration sensor 50 and fluctuations indicated by the sensor information output from normal position sensor 60. For example, the first threshold value may be set to a value greater than or equal to maximum fluctuations indicated by the sensor information output from normal acceleration sensor 50 and the sensor information output from normal position sensor 60. Since fluctuations indicated by the sensor information output from an anomalous sensor are sharp and exceed the first threshold value, it is possible from the above to determine the presence of anomalies.

Alternatively, for example, determiner 24 may determine the presence or absence of anomalies by making comparison between the physical quantities indicated by the sensor information output from each of the two sensors. However, it may be difficult to accurately compare the physical quantities having different dimensions. Thus, before the above comparison, determiner 24 may perform processing for matching different dimensions to each other on the sensor information output from each of the two sensors. For example, the dimensions may correspond to one of a change with time, a time derivative of the change, and a second-order time derivative of the change.

For example, in the case where processing for matching the dimension of a physical quantity to the dimension of a change with time is performed on the sensor information output from position sensor 60 and the sensor information output from acceleration sensor 50, it is possible to match the dimensions by double integration of the sensor information output from acceleration sensor 50. For example, in the case where processing for matching the dimension of a physical quantity to the dimension of a time derivative of the change with time is performed on the sensor information output from position sensor 60 and the sensor information output from acceleration sensor 50, it is possible to match the dimensions by integrating the sensor information output from acceleration sensor 50 and differentiating the sensor information output from position sensor 60. For example, in the case where processing for matching the dimension of a physical quantity to the dimension of a second-order time derivative of the change with time is performed on the sensor information output from position sensor 60 and the sensor information output from acceleration sensor 50, it is possible to match the dimensions by second-order derivation of the sensor information output from position sensor 60. For example, the above comparison may also be performed after processing for matching the dimension of a physical quantity to a lower dimension is performed on the sensor information output from position sensor 60 and the sensor information output from acceleration sensor 50.

As another alternative, for example, determiner 24 may determine the presence or absence of anomalies by comparing the physical quantities indicated by the sensor information output from each of the two sensors with a second threshold value. The second threshold value may, for example, be preset depending on the physical quantities indicated by the sensor information output from normal acceleration sensor 50 and the sensor information output from normal position sensor 60. For example, the second threshold value may be set to a value greater than the maximum physical quantities indicated by the sensor information output from normal acceleration sensor 50 and the sensor information output from normal position sensor 60. As yet another alternative, determiner 24 may determine the presence or absence of anomalies by performing frequency analysis on the sensor information output from each of the two sensors and comparing the acquired spectra with the second threshold value. If there is an anomaly in a sensor, frequency components in a specific frequency band may take on anomalous values. Thus, the execution of the frequency analysis allows accurate determination of the presence or absence of anomalies.

When the determination result indicates the presence of anomalies, determiner 24 may notify an external device of this fact.

Specific examples of the determination processing performed by determiner 24 (first to third examples) will be described later.

The following describes an example in which moving part 40 is located within a predetermined range from target position 66 for positioning, with reference to FIG. 2.

FIG. 2 is a perspective view of a production device (component mounter 5) to which motor control system 10 according to the embodiment has been applied. FIG. 2 also shows an upper perspective view of an area around imaging range 63 of position sensor 60 serving as an imaging device when position sensor 60 is located in the vicinity of target position 66. As illustrated in FIG. 2, in the case where the production device to which motor control system engine 10 has been applied is component mounter 5, acceleration sensor 50 and position sensor 60 are fixed to a header that serves as moving part 40 that is subjected to positioning control performed by motor 30.

Target position 66 is the position on substrate 65 on which a component transported by moving part 40 is mounted. A case where moving part 40 is included in a predetermined range from target position 66 for positioning may correspond to, for example, a case where target position 66 is included in imaging range 63 of position sensor 60. Note that when position sensor 60 is fixed to an object placed at target position 66, a case where moving part 40 is located within a predetermined range from target position 66 for positioning may correspond to, for example, a case where moving part 40 is included in imaging range 63 of position sensor 60.

Determiner 24 starts the determination processing when moving part 40 is located within a predetermined range from target position 66 for positioning, i.e., when moving part 40 is located around target position 66. This reduces processing loads on determiner 24. This is because, when moving part 40 is located away from target position 66 for positioning, moving part 40 is not captured by position sensor 60 (imaging device) and accordingly the sensor information output from position sensor 60 does not include information about the target position deviation of moving part 40. That is, the determination as to the presence or absence of anomalies in position sensor 60 is not possible with use of the sensor information that does not include information about the target position deviation of moving part 40, and it may become useless to perform the determination processing.

For example, the distance from marker 62 provided in imaging range 63 of position sensor 60 (e.g., the maker indicating the center of imaging range 63) to target position 66 seen in imaging range 63 may serve as information about the target position deviation of moving part 40. This distance indicates the amount of misregistration of moving part 40 from target position 66, and the position of moving part 40 is controlled so as to make the amount of misregistration approximately zero, i.e., to make marker 62 and target position 66 overlap each other in imaging range 63.

Next, the sensor information output from position sensor 60 and the sensor information output from acceleration sensor 50 will be described with reference to FIG. 3.

FIG. 3 is a diagram showing one example of the sensor information output from position sensor 60 and the sensor information output from acceleration sensor 50 according to the embodiment. In FIG. 3, (a1) to (a3) show the sensor information output from position sensor 60, and (b1) to (b3) show the sensor information output from acceleration sensor 50.

In FIG. 3, (a1) and (b1) show the sensor information when both position sensor 60 and acceleration sensor 50 are normal. On the other hand, (a2) and (b2) in FIG. 3 show the sensor information when position sensor 60 is anomalous (specifically, the fastening of position sensor 60 to moving part 40 is anomalous) and acceleration sensor 50 is normal. As indicated by the broken line in (a2) in FIG. 3, it can be seen that anomalies in position sensor 60 appear in the sensor information. Moreover, (a3) and (b3) in FIG. 3 show the spectra obtained from the frequency analysis of the sensor information shown in (a2) and the sensor information shown in (b2) in FIG. 3. As shown in (a3) and (b3) in FIG. 3, the frequency analysis of the sensor information reveals a considerable difference in spectrum between anomalous position sensor 60 and normal acceleration sensor 50 at specific frequencies (e.g., at frequencies in the areas surrounded by the broken lines in (a3) and (b3) in FIG. 3).

Determiner 24 determines the presence or absence of anomalies in at least one of the two sensors by using such sensor information and the spectra obtained from the frequency analysis of the sensor information.

Next, specific examples of the operations performed by anomaly determining device 25 will be described, citing first to third examples.

FIG. 4 is a flowchart showing a first example of the operations performed by anomaly determining device 25 according to the embodiment.

First, sensor information acquirer 23 acquires time-series data on position sensor 60 and time-series data on acceleration sensor 50 (step S10).

Next, determiner 24 matches the dimensions of each data (step S11). As described above, determiner 24 performs processing for matching the dimension of the physical quantity indicated by the time-series data output from each of the two sensors to the dimension of one of a change over time, a time derivative of the change, and a second-order time derivative of the change.

Next, determiner 24 calculates a difference value between each data that has undergone dimension matching (step S12), and determines whether the difference value exceeds a threshold value to discriminate between the presence or absence of anomalies in the sensors (step S13). For example, the threshold value may be set to a value greater than a maximum difference value between the data on normal acceleration sensor 50 and the data on normal position sensor 60, both having undergone dimension matching. If there is an anomaly in one of the two sensors, the time-series data on the anomalous sensor may take on an anomalous value and the difference value may increase. Accordingly, if the difference value exceeds the threshold value, it is possible to determine that there is an anomaly in one of the two sensors.

Then, determiner 24 outputs the presence or absence of anomalies in the sensors (step S14).

FIG. 5 is a flowchart showing a second example of the operations performed by anomaly determining device 25 according to the embodiment.

First, sensor information acquirer 23 acquires time-series data on position sensor 60 and time-series data on acceleration sensor 50 (step S20).

Next, determiner 24 removes specific frequency components from each data (step S21). For example, unnecessary frequency components such as high frequency components are removed.

Next, determiner 24 performs frequency analysis of each data (step S22). For example, determiner 24 performs Fast Fourier Transform (FFT) analysis. Accordingly, it is possible to discriminate between the presence and absence of anomalies by using spectra obtained from the frequency analysis of each data.

Next, determiner 24 sets different threshold values for the spectrum calculated from the sensor information on position sensor 60 and the spectrum calculated from the sensor information on acceleration sensor 50 (step S23), and determines whether each spectrum exceeds its threshold value to discriminate between the presence and absence of anomalies in sensors (step S24). The different threshold values are set because the physical quantity (position) indicated by the sensor information on position sensor 60 and the physical quantity (acceleration) indicated by the sensor information on acceleration sensor 50 are on different dimensional levels, and therefore it is difficult to set the same threshold value. For example, each threshold value may be set to a value greater than a maximum value of frequency components in a specific frequency band in the spectra calculated from the sensor information output from normal acceleration sensor 50 and the sensor information output from normal position sensor 60. In the spectrum calculated from the sensor information on an anomalous sensor, frequency components in a specific frequency band may take on anomalous values that may increase. Accordingly, if the value of frequency components in a specific frequency band exceeds the threshold value, it is possible to determine that there is an anomaly in the corresponding sensor.

Then, determiner 24 outputs the presence or absence of anomalies in the sensors (step S25).

FIG. 6 is a flowchart showing a third example of the operations performed by anomaly determining device 25 according to the embodiment.

First, sensor information acquirer 23 acquires time-series data on position sensor 60 and time-series data on acceleration sensor 50 (step S30).

Next, determiner 24 matches the dimensions of each data (step S31). As described above, determiner 24 performs processing for matching the dimension of the physical quantity indicated by the time-series data output from each of the two sensors to the dimension of one of a change over time, a time derivative of the change, and a second-order time derivative of the change.

Next, determiner 24 removes specific frequency components from each data that has undergone dimension matching (step S32). For example, unnecessary frequency components such as high frequency components are removed.

Next, determiner 24 performs frequency analysis of each data (step S33). For example, determiner 24 may perform FFT analysis. Accordingly, it is possible to discriminate between the presence and absence of anomalies by using spectra obtained from the frequency analysis of each data.

Note that the processing in step S32 may be performed after execution of the processing in step S33.

Next, determiner 24 sets the same threshold value for the spectrum calculated from the sensor information on position sensor 60 and the spectrum calculated from the sensor information on acceleration sensor 50 (step S34), and discriminates between the presence and absence of anomalies in the sensors by determining whether each spectrum exceeds the threshold value (step S35). Here, the same threshold value can be set for both of the spectra because the dimension of the physical quantity (position) indicated by the sensor information on position sensor 60 and the dimension of the physical quantity (acceleration) indicated by the sensor information on acceleration sensor 50 are matched to each other. For example, the threshold value may be set to a value greater than a maximum value of frequency components in a specific frequency band in the spectra calculated from the sensor information that has undergone dimension matching and output from normal acceleration sensor 50 and normal position sensor 60. In the spectrum calculated from the sensor information on an anomalous sensor, the frequency components in a specific frequency band may take on an anomalous value that may increase. Accordingly, if the value of frequency components in a specific frequency band exceeds the threshold value, it is possible to determine that there is an anomaly in the corresponding sensor.

Then, determiner 24 outputs the presence or absence of anomalies in the sensors (step S36).

As described above, anomaly determining device 25 automatically determines the presence or absence of anomalies in at least one of the two sensors (e.g., position sensor 60 and acceleration sensor 50) that detect different physical quantities. Accordingly, it is possible to easily determine the presence or absence of anomalies in the sensors. Moreover, it is possible to determine the presence or absence of anomalies by further performing processing for matching dimensions or performing frequency analysis on the information output from each of the two sensors.

Although the above embodiment has described an example in which two sensors are used to detect the physical quantities of moving part 40, three or more sensors may be used to detect the physical quantities of moving part 40. This will be described with reference to FIG. 7.

FIG. 7 is a block diagram illustrating a configuration of motor control system 10a according to a variation of the embodiment.

Motor control system 10a differs from motor control system 10 according to the embodiment in that it further includes acceleration sensor 52 and junction 53. The other points are the same as those in the embodiment, and therefore description thereof shall be omitted.

Acceleration sensor 52 is fixed to moving part 40 and configured to detect the acceleration of moving part 40 and to output sensor information indicating the detected time-series acceleration of moving part 40 to motor control device 20 (specifically, anomaly determining device 25). Assuming that x and y axial directions are perpendicular to each other in one plane, for example, acceleration sensor 50 may serve as a sensor that detects the acceleration of moving part 40 in the x axial direction, and acceleration sensor 52 may serve as a sensor that detects the acceleration of moving part 40 in the y axial direction.

Junction 53 is a fastening member for fixing acceleration sensor 52 to moving part 40. For example, the fastening of acceleration sensor 52 to moving part 40 may be loosened due to aged deterioration. In particular, the fastening of acceleration sensor 52 to moving part 40 is likely to be loosened due to oscillations or the like associated with the movement of moving part 40.

In this way, three or more sensors may serve to detect the physical quantities of moving part 40. At this time, sensor information acquirer 23 may acquire sensor information output in time sequence from each of the three or more sensors, and when moving part 40 is located within a predetermined range from target position 66 for positioning, determiner 24 may determine the presence or absence of anomalies in at least one of the three or more sensors in accordance with the acquired sensor information and may output the result of the determination.

### [Other Embodiments]

Although anomaly determining device 25 and motor control device 20 according to one or a plurality of aspects of the present disclosure have been described thus far in accordance with the embodiments, the present disclosure is not limited to these embodiments. The present disclosure may also include other variations, such as those obtained by applying various modifications conceivable by those skilled in the art to the embodiments or those configured by combining constituent elements described in different embodiments together, without departing from the scope of the present disclosure.

The present disclosure is implemented not only as anomaly determining device 25 and motor control device 20, but also as an anomaly determining method that includes steps (processing) performed by constituent elements that configure anomaly determining device 25.

FIG. 8 is a flowchart showing one example of the anomaly determining method according to another embodiment.

The anomaly determining method is a method to be executed by a computer (e.g., anomaly determining device 25) and includes a sensor-information acquisition step (step S1) and a determination step (S2) as illustrated in FIG. 8. The sensor-information acquisition step is acquiring sensor information that is output in time sequence from each of the two sensors that detect different physical quantities of the moving part that is subjected to positioning control. The determination step is, when the moving part is located within a predetermined range from the target position for positioning, determining the presence or absence of anomalies in at least one of the two sensors, in accordance with the acquired sensor information, and outputting the result of the determination.

For example, the present disclosure may be implemented as a program for causing a processor to execute the steps included in the anomaly determining method. Moreover, the present disclosure may also be implemented as a non-transitory computer-readable recording medium such as a CD-ROM that records that program.

For example, in the case where the present disclosure is implemented as a program (software), each step is executed by execution of a program using hardware resources of the computer such as a CPU, memories, and an input/output circuit. That is, each step is executed by the CPU acquiring and computing data output from, for example, the memories or the input/output circuit or outputting the result of the arithmetic operations to, for example, the memories or the input/output circuit.

In the above-described embodiments, each constituent element included in anomaly determining device 25 and motor control device 20 may be configured as dedicated hardware or implemented by executing software programs suitable for each constituent element. Each constituent element may be implemented by a program executor, such as the CPU or the processor, reading out and executing software programs recorded on a recording medium such as a hard disk or a semiconductor memory.

Some or all of the functions of anomaly determining device 25 and motor control device 20 are implemented as an LSI that typically serves as an integrated circuit. These functions may be individually mounted on a signal chip, or some or all of the functions may be mounted on a single chip. The method of circuit integration is not limited to the one using an LSI, and may be implemented as a dedicated circuit or a general-purpose processor. The method of circuit integration may also use a field programmable gate array (FPGA) that enables programming after manufacture of an LSI, or a reconfigurable processor capable of reconfiguring connections or settings of circuit cells inside an LSI.

### [Industrial Applicability]

The present disclosure is widely applicable to, for example, a system in which the position of a moving part is controlled by a motor.

### [Reference Signs List]

- 5: component mounter
- 10, 10a: motor control system
- 20: motor control device
- 21: command acquirer
- 22: position controller
- 23: sensor information acquirer
- 24: determiner
- 25: anomaly determining device
- 30: motor
- 31: encoder
- 40: moving part
- 50, 52: acceleration sensor
- 51, 53, 61: junction
- 60: position sensor
- 63: imaging range
- 65: substrate
- 66: target position

## Claims

1. An anomaly determining device comprising:
a sensor information acquirer that acquires sensor information output in time sequence from each of two sensors that detect different physical quantities of a moving part that is subjected to positioning control; and
a determiner that, when the moving part is located within a predetermined range from a target position for positioning, determines presence or absence of an anomaly in at least one of the two sensors in accordance with the sensor information acquired and outputs a result of the determination.

2. The anomaly determining device according to claim 1,
wherein the two sensors include an acceleration sensor and a position sensor, the acceleration sensor detecting and outputting an acceleration of the moving part, the position sensor detecting and outputting a location deviation of the moving part from the target position.

3. The anomaly determining device according to claim 2,
wherein the acceleration sensor is fixed to the moving part, and
the position sensor is fixed to the moving part or an object that is different from the moving part and placed at the target position.

4. The anomaly determining device according to any one of claims 1 to 3,
wherein the determiner determines the presence or absence of an anomaly by comparing a fluctuation indicated by the sensor information output from at least one of the two sensors with a first threshold value.

5. The anomaly determining device according to any one of claims 1 to 3,
wherein the determiner determines the presence or absence of an anomaly by making a comparison between physical quantities indicated by the sensor information output from each of the two sensors.

6. The anomaly determining device according to claim 5,
wherein the determiner performs the comparison after performing processing for matching a dimension of a physical quantity indicated by the sensor information output from each of the two sensors to a dimension of one of a change over time, a time derivative of the change, and a second-order time derivative of the change.

7. The anomaly determining device according to any one of claims 1 to 3,
wherein the determiner determines the presence or absence of an anomaly by comparing a physical quantity indicated by the sensor information output from each of the two sensors with a second threshold value.

8. The anomaly determining device according to claim 7,
wherein the determiner determines the presence or absence of an anomaly by performing frequency analysis on the sensor information output from each of the two sensors and comparing a spectrum obtained with the second threshold value.

9. A motor control device for controlling a position of a moving part by driving a motor, the motor control device comprising:
the anomaly determining device according to any one of claims 1 to 8.

10. An anomaly determining method to be executed by a computer, the anomaly determining method comprising:
acquiring sensor information output in time sequence from each of two sensors that detect different physical quantities of a moving part that is subjected to positioning control; and
when the moving part is located within a predetermined range from a target position for positioning, determining presence or absence of an anomaly in at least one of the two sensors in accordance with the sensor information acquired, and outputting a result of the determining.

11. A program for causing a computer to execute steps included in the anomaly determining method according to claim 10.
